# EUROPEAN PATENT APPLICATION

(11) **EP 1 276 260 A2**
(43) Date of publication of application: **15.01.2003**
(21) Application number: 02012478.0
(22) Date of filing: 12.06.2002
(51) Int. Cl.: H04J 3/04, H04N 5/04, H03K 19/00

(54) **Differential signal-delaying apparatus, receiver employing the apparatus, and communication system**

(30) Priority: 18.06.2001 JP 2001183183
(71) Applicant: MATSUSHITA ELECTRIC INDUSTRIAL CO., LTD., Kadoma-shi, Osaka 571-8501 (JP)
(72) Inventor: Satoshi, Hasako, Iizukashi, Fukuokaken (JP); Yuji, Igata, Tukushinoshi, Fukuoka (JP); Masahiro, Maki, Iizukashi, Fukuokaken (JP); Junji, Kondou, Tagawagun, Fukuokaken (JP)
(74) Representative: Balsters, Robert

(57) **Abstract**

Two different delay unit(41,42) delays first and second signals of a differential signal, thereby generating two different delay signals, respectively. A delay control unit(45) controls respective delay times in the two different delay unit(41,42), thereby varying a delay time difference that is a difference between the respective delay times in the two different delay unit(41,42). An error-detecting unit(43) detects an error in a signal for each change in delay time deference, which signal is based on the differential signal. A counting unit(44) counts the number of times of errors per predetermined time. The delay control unit(45) sets the respective delay times in the two different delay unit(41,42) to a delay time difference in which the number of times of errors per predetermined time is minimized. As a result, the occurrence of differential signal skew-caused errors is suppressed to an extreme extent.

## Description

This invention relates to a differential signal-delaying apparatus for delaying a received differential signal in data transmission through a differential signal, and an art related thereto.

A specification published on April 2, 1999, entitled "Digital Visual Interface Revision 1.0" (hereinafter called a "DVI specification") (refer to http://www.ddwg.org/) has heretofore been established as a standard of an art for transmitting digital video data at high speeds through a differential signal.

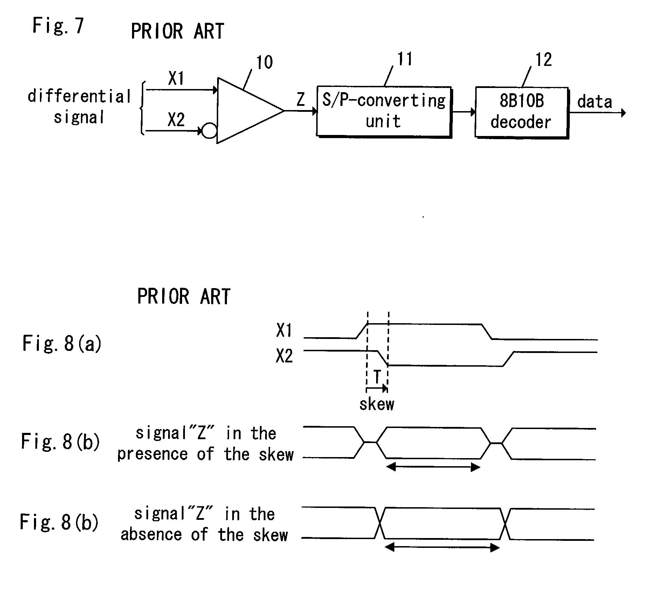

Fig. 7 is a block diagram, illustrating a prior art receiver constructed according to the DIV specification. As illustrated in Fig. 7, the receiver includes a differential-amplifying unit 10, a serial/parallel-converting unit (or a S/P-converting unit) 11, and an 8B10B decoder 12.

The differential-amplifying unit 10 receives a differential signal that is sent from a transmitter (not shown) through a pair cable. The differential signal includes one signal X1 and another X2, each of which is a serial signal and 10-bit redundant code.

The differential-amplifying unit 10 generates signal "Z" according to a potential difference between signals X1, X2.

The S/P-converting unit 11 converts signal Z (a serial signal) from the differential-amplifying unit 11 into a parallel signal.

The 8B10B decoder 12 decodes the parallel signal (a 10-bit redundant code) from the S/P-converting unit 11, and then provides the decoded signal as 8-bit parallel data.

However, the prior art receivers as discussed above fail to deal with data errors caused by a differential signal skew (a difference in time of differential signal arrival). Such a drawback will now be described in detail.

Fig. 8 is an illustration, showing timing in order to describe how adversely the differential signal skew affects. Fig. 8 (a) is a descriptive illustration, showing the screw. Fig. 8 (b) illustrates an eye pattern (an overwritten waveform) of output signal "Z" from the differential-amplifying unit 10 in the presence of the differential signal skew. Fig. 8 (c) illustrates another eye pattern (an overwritten waveform) of the same output signal "Z" but in the absence of the skew.

As shown in Fig. 8 (a), arrival time difference "T" occurs between one signal X1 and another X2, both of which form a differential signal to be fed into the differential-amplifying unit 10. The arrival time difference "T", a difference in time in which one signal X1 and another X2 reach the differential-amplifying unit 10, denotes the differential signal skew.

It should be noted that the differential signal skew as set forth herein refers to an "intra-pair-skew" as discussed in the DVI specification, but differs from an "inter-pair-skew" as given in the same DVI specification.

It can be seen from Figs. 8(b) and 8(c) that eye pattern openness in a direction of time lapse is made smaller in the presence of the differential signal skew as illustrated in Fig. 8 (b) than that in the absence of the differential signal skew as illustrated in Fig. 8 (c).

This means that data is set to be either 0 or 1 at smaller time intervals in the presence of the skew (Fig. 8 (b)) than in the absence of the skew (Fig. 8 (c)). This brings about a problem that a data value is decided with less certainty.

It has been known that the differential signal screw increases with an increase in length of a pair cable for use in transmission of the differential signal. As a result, the data value is decided with further less certainty.

An example will now be described as to how adversely an increase in length of the pair cable affects. A vide-transmitting system according to the DVI specification typically employs a pair cable having a length ranging from 2 to 5 meters. In the future, the vide-transmitting system is expected to use a longer pair cable.

The use of such a longer pair cable is likely to disturb a video image on the prior art receiver because of differential signal skew-caused data errors.

A prior art digital variable delay circuit is disclosed in published Japanese Patent Application Laid-Open No. 4-227313. The digital variable delay circuit delays an entered differential signal for output thereof. At that time, delay time is adjusted by the adjustment of a value of a current from a variable electrical current source.

However, a purpose of the digital variable delay circuit is to merely control the delay time, not to suppress the differential signal skew-caused errors. Consequently, the circuit as described above is free of countermeasures to suppress such the errors.

In view of the above, an object of the present invention is to provide a differential signal-delaying apparatus capable of inhibiting the occurrence of differential signal skew-caused errors to the utmost regardless of whether or not a pair cable for transmitting a differential signal is great in length, and further to provide an art related thereto.

A first aspect of the present invention provides a differential signal-delaying apparatus comprising a first delay unit for delaying a first signal of an entered differential signal in order to generate a first delay signal, a second delay unit for delaying a second signal of the entered differential signal in order to generate a second delay signal, an error-detecting unit for generating an error signal when detecting an error in a signal that is based on the first and second delay signals, a counting unit for counting the number of times of errors per predetermined time upon receipt of the error signal, and a delay control unit for varying a delay time difference that is a difference between respective delay times in the first and second delay unit, wherein the counting unit counts the number of times of errors per predetermined time for each change in delay time difference to be made by the delay control unit, while the delay control unit sets the respective delay times in the first and second delay unit to respective delay times that determine a delay time difference in which the number of times of errors per predetermined time is minimized.

The above-structured differential signal-delaying apparatus practices the above delay time-setting operation including the step of locating the delay time difference in which the number of times of errors per predetermined time is minimized, and thereby provides a minimized differential signal skew. As a result, the occurrence of differential signal skew-caused errors is inhibited to an extreme extent. This beneficial effect is provided regardless of whether or not a pair cable for use in feeding the differential signal is large in length.

According to a second aspect of the present invention, in a differential signal-delaying apparatus as defined in the first aspect of the invention, the delay control unit starts changing the delay time difference either when the differential signal-delaying apparatus is switched on or when a pair cable for use in entering the differential signal is inserted. Then, the delay control unit sets the respective delay times in the first and second delay unit to respective delay times that determine a delay time difference in which the number of times of errors per predetermined time is minimized.

The above-structured differential signal-delaying apparatus ensures that the delay time difference in which the number of times of errors per predetermined time is minimized is located when there is a possibility of pair cable replacement. As a result, the differential signal-delaying apparatus is able to handle a possible change in differential signal skew.

According to a third aspect of the present invention, in a differential signal-delaying apparatus as defined in the first aspect of the invention, the delay control unit deactivates the error-detecting unit and the counting unit when setting the respective delay times in the first and second delay unit.

The above-structured differential signal-delaying apparatus reduces power consumption.

A fourth aspect of the invention provides a differential signal-delaying apparatus comprising a first delay unit for delaying a first signal of an entered differential signal in order to generate a first delay signal, a second delay unit for delaying a second signal of the entered differential signal in order to generate a second delay signal, an error-detecting unit for detecting an error in a signal that is based on the first and second delay signals, and a delay control unit for varying a delay time difference that is a difference between respective delay times in the first and second delay unit, wherein the error-detecting unit detects the error for each change in delay time difference to be made by the delay control unit, while the delay control unit sets the respective delay times in the first and second delay unit to respective delay times that determine a delay time difference in which no error is detected.

The above-constructed differential signal-delaying apparatus practices the above delay time-setting operation including the step of locating the delay time difference in which no error is detected, and thereby provides a minimized differential signal skew. As a result, the occurrence of differential signal skew-caused errors is suppressed to the greatest degree. This beneficial effect is provided regardless of whether or not a pair cable for use in feeding the differential signal is large in length. In addition, the differential signal-delaying apparatus as discussed above eliminates a counter for counting the number of times of errors, and such a simpler construction is able to achieve the above beneficial effect.

According to a fifth aspect of the invention, in a differential signal-delaying apparatus as defined in the fourth aspect of the invention, the delay control unit starts changing the delay time difference either when the differential signal-delaying apparatus is switched on or when a pair cable for use in entering the differential signal is inserted. Then, the delay control unit sets the respective delay times in the first and second delay unit to respective delay times that determine a delay time difference in which no error is detected.

The above-constructed differential signal-delaying apparatus ensures that the delay time difference in which no error is detected is located when there is a likelihood of pair cable replacement. As a result, the differential signal-delaying apparatus is able to handle a possible change in differential signal skew.

According to a sixth aspect of the present invention, in a differential signal-delaying apparatus as defined in the fourth aspect of the invention, the delay control unit deactivates the error-detecting unit when setting the respective delay times in the first and second delay unit.

The above construction reduces power consumption.

According to the seventh aspect of the present invention, in a differential signal-delaying apparatus as defined in the first or fourth aspect of the invention, the delay control unit varies the delay time difference by controlling the respective delay times in the first and second delay unit by means of first and second control signals to be fed into the first and second delay unit, respectively, wherein the delay time in the first delay unit is linearly varied with a voltage of the first control signal, while the delay time in the second delay unit is linearly varied with a voltage of the second control signal.

The above-structured differential signal-delaying apparatus provides easy control over the delay time difference.

An eighth aspect of the present invention provides a receiver for receiving a differential signal that includes first and second signals, each of which is a serial signal, comprising a differential signal-delaying unit for delaying the first and second signals of the differential signal in order to provide the delayed first and second signals as first and second delay signals, respectively, a differential-amplifying unit for generating an output signal according to a potential difference between the first and second delay signals, a serial/parallel-converting unit for converting the output signal into a parallel signal, which output signal is a serial signal sent out from the differential-amplifying unit, and a decoder for decoding the parallel signal from the serial/parallel-converting unit, the differential signal-delaying unit comprising a first delay unit for delaying the first signal of the differential signal in order to generate the first delay signal, a second delay unit for delaying the second signal of the differential signal in order to produce the second delay signal, an error-detecting unit for generating an error signal when detecting an error in the parallel signal from the serial/parallel-converting unit, a counting unit for counting the number of times of errors per predetermined time upon receipt of the error signal, and a delay control unit for varying a delay time difference that is a difference between respective delay times in the first and second delay unit, wherein the counting unit counts the number of times of errors per predetermined time for each change in delay time difference to be made by the delay control unit, while the delay control unit sets the respective delay times in the first and second delay unit to respective delay times that determine a delay time difference in which the number of times of errors per predetermined time is minimized.

The above-structured differential signal-delaying unit having the above construction practices the above delay time-setting operation including the step of locating the delay time difference in which the number of times of errors per predetermined time is minimized, and thereby provides a minimized differential signal skew. As a result, the occurrence of differential signal skew-caused errors is suppressed to the utmost. This beneficial effect is achievable regardless of whether or not a pair cable for use in receiving the differential signal is great in length.

According to a ninth aspect of the present invention, in a receiver as defined in the eight aspect of the invention, the delay control unit starts changing the delay time difference either when the receiver is switched on or when a pair cable for use in feeding the differential signal is inserted into the receiver, and then the delay control unit sets the respective delay times in the first and second delay unit to respective delay times that determine a delay time difference in which the number of times of errors per predetermined time is minimized.

The above-constructed differential signal-delaying unit ensures that the delay time difference in which the number of times of errors per predetermined time is minimized is located when there is a likelihood of pair cable replacement. As a result, the differential signal-delaying unit is able to take care of a possible change in the differential signal skew.

According to a tenth aspect of the present invention, in a receiver as defined in the eighth aspect of the invention, the delay control unit deactivates the error-detecting unit and the counting unit when setting the respective delay times in the first and second delay unit.

This construction reduces power consumption.

An eleventh aspect of the present invention provides a receiver for receiving a differential signal that includes first and second signals, each of which is a serial signal, comprising a differential signal-delaying unit for delaying the first and second signals of the differential signal in order to provide the delayed first and second signals as first and second delay signals, respectively, a differential-amplifying unit for generating an output signal according to a potential difference between the first and second delay signals, a serial/parallel-converting unit for converting the output signal into a parallel signal, which output signal is a serial signal sent out from the differential-amplifying unit, and a decoder for decoding the parallel signal from the serial/parallel-converting unit, the differential signal-delaying unit comprising a first delay unit for delaying the first signal of the differential signal in order to generate the first delay signal, a second delay unit for delaying the second signal of the differential signal in order to produce the second delay signal, an error-detecting unit for detecting an error in the parallel signal from the serial/parallel-converting unit, and a delay control unit for varying a delay time difference that is a difference between respective delay times in the first and second delay unit, wherein the error-detecting unit detects the error for each change in delay time difference to be made by the delay control unit, while the delay control unit sets the respective delay times in the first and second delay unit to respective delay times that determine a delay time difference in which no error is detected.

The above-structured differential signal-delaying unit practices the above delay time-setting operation including the step of locating the delay time difference in which no error is detected, and thereby provides a minimized differential signal skew. As a result, the occurrence of differential signal skew-caused errors is suppressed to an extreme extent. This beneficial effect is achievable regardless of whether or not a pair cable for use in receiving the differential signal is great in length. In addition, the differential signal-delaying unit as discussed above is free of a counter for counting the number of times of errors, and such a simpler construction is able to achieve the above beneficial effect.

According to a twelfth aspect of the present invention, in a receiver as defined in the eleventh aspect of the invention, the delay control unit starts changing the delay time difference either when the receiver is switched on or when a pair cable for use in feeding the differential signal is inserted into the receiver, and then the delay control unit sets the respective delay times in the first and second delay unit to respective delay times that determine a delay time difference in which no error is detected.

The above-constructed differential signal-delaying unit ensures that the delay time difference in which no error is detected is located when there is a possibility of pair cable replacement. As a result, the differential signal-delaying unit is able to take care of a possible change in a differential signal skew.

According to a thirteenth aspect of the present invention, in a receiver as defined in the eleventh aspect of the invention, the delay control unit deactivates the error-detecting unit when setting the respective delay times in the first and second delay unit.

This construction reduces power consumption.

According to a fourteenth aspect of the present invention, in a receiver as defined in the eighth or eleventh aspect of the invention, the receiver receives the differential signal that includes first and second signals, each of which is a 10-bit redundant code, while the decoder decodes the parallel signal from the serial/parallel-converting unit, which parallel signal is the 10-bit redundant code, and thereby provides the decoded parallel signal as 8-bit parallel data.

The above-constructed receiver is possible to handle a redundant code produced by means of an encoding algorithm according to the DVI specification.

According to a fifteenth aspect of the present invention, in a receiver as defined in the eighth or eleventh aspect of the invention, the delay control unit varies the delay time difference by controlling the respective delay times in the first and second delay unit by means of first and second control signals to be entered into the first and second delay unit, respectively. The delay time in the first delay unit is linearly varied with a voltage of the first control signal, while the delay time in the second delay unit is linearly varied with a voltage of the second control signal.

The above-structured delay control unit realizes easy control over the delay time difference.

A sixteenth aspect of the present invention provides a communication system including a transmitter and a receiver, which are communicated with one another through a pair cable, the receiver receiving a differential signal from the transmitter, the receiver comprising a differential signal-delaying unit for delaying the differential signal, the differential signal-delaying unit comprising a first delay unit for delaying a first signal of the differential signal in order to generate a first delay signal, a second delay unit for delaying a second signal of the differential signal in order to generate a second delay signal, an error-detecting unit for generating an error signal when detecting an error in a signal that is based on the first and second delay signals, a counting unit for counting the number of times of errors per predetermined time upon receipt of the error signal, and a delay control unit for varying a delay time difference that is a difference between respective delay times in the first and second delay unit, wherein the counting unit counts the number of times of errors per predetermined time for each change in delay time difference to be made by the delay control unit, while the delay control unit sets the respective delay times in the first and second delay unit to respective delay times that determine a delay time difference in which the number of times of errors per predetermined time is minimized.

The above-structured differential signal-delaying unit practices the above delay time-setting operation including the step of locating the delay time difference in which the number of times of errors per predetermined time is minimized, and thereby provides a minimized differential signal skew. As a result, the occurrence of differential signal skew-caused errors is suppressed to an extreme extent. This beneficial effect is achievable regardless of whether or not a pair cable for use in transmitting the differential signal is large in length.

A seventeenth aspect of the present invention provides a communication system including a transmitter and a receiver, which are communicated with one another through a pair cable, the receiver receiving a differential signal from the transmitter, the receiver comprising a differential signal-delaying unit for delaying the differential signal, the differential signal-delaying unit comprising a first delay unit for delaying a first signal of the differential signal in order to generate a first delay signal, a second delay unit for delaying a second signal of the differential signal in order to generate a second delay signal, an error-detecting unit for detecting an error in a signal that is based on the first and second delay signals, and a delay control unit for varying a delay time difference that is a difference between respective delay times in the first and second delay unit, wherein the error-detecting unit detects the error for each change in delay time difference to be made by the delay control unit, while the delay control unit sets the respective delay times in the first and second delay unit to respective delay times that determine a delay time difference in which no error is detected.

The above-structured differential signal-delaying unit practices the above delay time-setting operation including the step of locating the delay time difference in which no error is detected, and thereby provides a minimized differential signal skew. As a result, the occurrence of differential signal skew-caused errors is inhibited to the largest extent. This beneficial effect is achievable regardless of whether or not a pair cable for use in transmitting the differential signal is large in length. In addition, the differential signal-delaying unit as discussed above is free of a counter for counting the number of times of errors, and such a simper structure is able to achieve the beneficial effect.

The above, and other objects, features and advantages of the present invention will become apparent from the following description read in conjunction with the accompanying drawings, in which like reference numerals designate the same elements.

### BRIEF DESCRIPTION OF THE DRAWINGS

Fig. 1 is a block diagram, illustrating a communication system according to a first embodiment of the present invention;
Fig. 2 is a block diagram, illustrating a receiver as illustrated in Fig. 1;
Fig. 3 (a) is a descriptive illustration, showing a delay unit of Fig. 2;
Fig. 3 (b) is a descriptive illustration, showing the delay unit of Fig. 2;
Fig. 3 (c) is a descriptive illustration, showing the delay unit of Fig. 2;
Fig. 3 (d) is a descriptive illustration, showing the delay unit of Fig. 2;
Fig. 4 is a descriptive illustration, showing an adjustment mode that a differential signal-delaying unit of Fig. 2 assumes;
Fig. 5 (a) is an illustration, showing a waveform of an output signal from a differential-amplifying unit when the differential signal-delaying unit is in the adjustment mode;
Fig. 5 (b) is an illustration, showing a waveform of an output signal from the differential-amplifying unit when the differential signal-delaying unit is in a fixed mode;
Fig. 6 is a block diagram, illustrating a receiver according to a second embodiment;
Fig. 7 is a block diagram, illustrating a receiver in a prior art communication system;
Fig. 8 (a) is a descriptive illustration, showing a differential signal skew;
Fig. 8 (b) is an illustration, showing a waveform of an output signal from a differential-amplifying unit in the presence of the differential signal skew; and,
Fig. 8 (c) is an illustration, showing a waveform of an output signal from the differential-amplifying unit in the absence of the skew.

Embodiments of the present invention will now be described with reference to the drawing.

### (Embodiment 1)

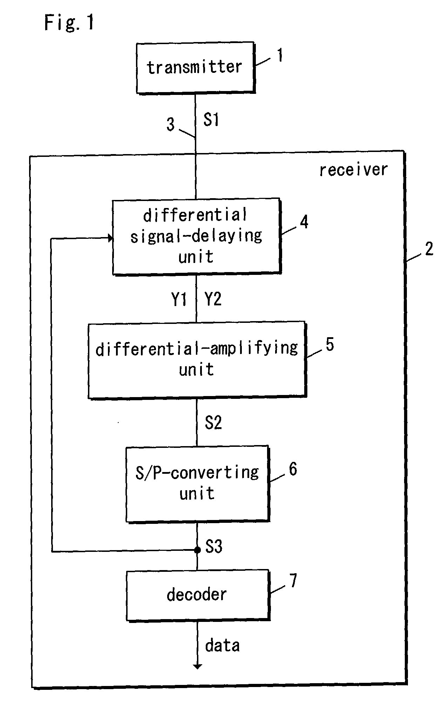

Fig. 1 is a block diagram, illustrating a communication system according to a first embodiment of the present invention. As illustrated in Fig. 1, the communication system includes a transmitter 1 and a receiver 2. A pair cable 3 interconnects the transmitter 1 and the receiver 2.

The receiver 2 includes a differential signal-delaying unit 4, a differential-amplifying unit 5, a serial/parallel-converting unit (S/P-converting unit) 6, and a decoder 7.

The transmitter 1 encodes display information, e.g., a video signal, thereby producing a redundant code. The transmitter 1 generates differential signal "S1" according to the resulting redundant code, and then sends differential signal S 1 to the receiver 2 through the pair cable 3.

It may more specifically be assumed that the transmitter 1 and receiver 2 are replaced by, e.g., a set-top box (STB) and a television, respectively.

Differential signal S1 includes one signal X1 and another X2, which are serial signals and which are opposite in polarity to one another.

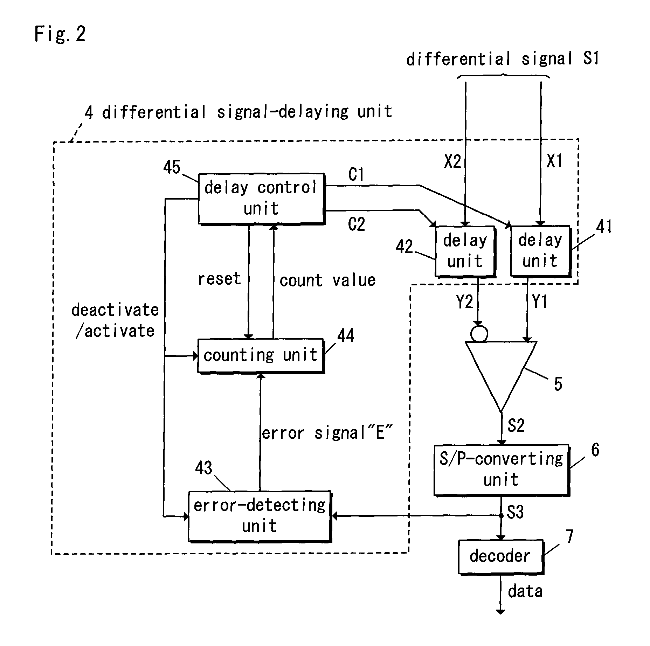

Fig. 2 is a block diagram, illustrating the receiver 2 of Fig. 1. In Fig. 2, the same components as those of Fig. 1 are identified by the same reference characters.

As illustrated in Fig. 2, the differential signal-delaying unit 4 includes a pair of delay unit 41, 42, an error-detecting unit 43, a counting unit 44, and a delay control unit 45.

It will now be described how the above components in the receiver 2 behave. The pair of delay unit 41, 42 will initially be discussed about behavior thereof.

One signal X1 is fed into the delay unit 41. The delay unit 41 delays the fed signal X1 in accordance with control signal C1 from the delay control unit 45, and then provides the delayed signal X1 as delay signal Y1.

Another signal X2 is entered into the delay unit 42. The delay unit 42 delays the fed signal X2 in accordance with control signal C2 from the delay control unit 45, and then provides the delayed signal X2 as delay signal Y2.

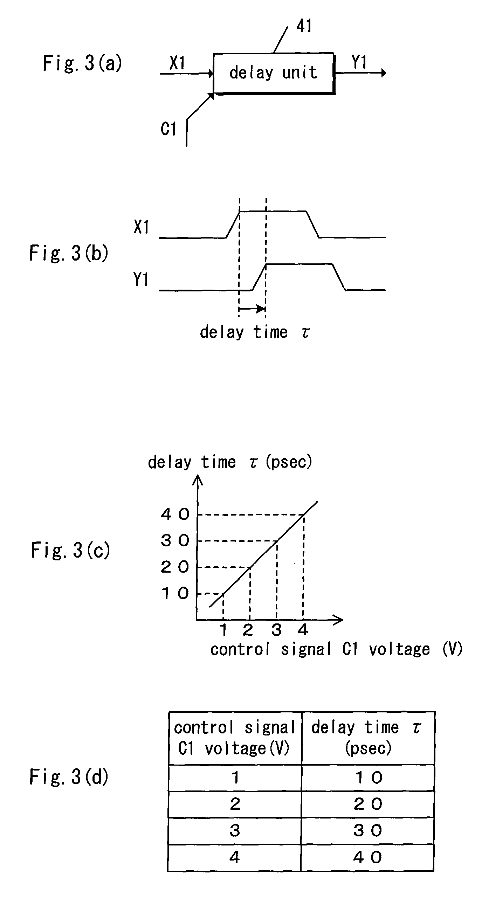

Fig. 3 is a descriptive illustration, showing details of behavior provided by the delay unit 41 of Fig. 2. Fig. 3 (a) is an illustration, showing how the signals enter and leave the delay unit 41. Fig. 3 (b) is a descriptive illustration, showing delay time in the delay unit 41. Fig. 3 (c) is a graph, illustrating a relationship between a voltage (V) of control signal C1 to be sent to the delay unit 41 and the delay time (psec) in the delay unit 41. Fig. 3 (d) is a table, illustrating a relationship between the voltage (V) of control signal C1 and the delay time (psec) in the delay unit 41.

As illustrated in Figs. 3 (a) and 3 (b), the delay unit 41 delays the entered signal X1 by an amount of delay time τ in accordance with control signal C1, and then provides the delayed signal X1 as delay signal Y1.

As illustrated in Figs. 3 (c) and 3 (d), delay time τ in the delay unit 41 is linearly varied with the voltage of control signal C1.

Similar to the above, a delay time in the delay unit 42 is linearly varied with a voltage of control signal C2 that is sent from the delay control unit 45, and assumes characteristics as illustrated in Figs. 3 (c), 3 (d).

Although the linear variations of the respective delay times in the delay unit 41, 42 with the respective voltages of control signals Cl, C2 have been described by way of illustration, the present invention is not limited thereto. Any relationship between the delay times in the delay unit 41, 42 and the voltages of control signals C1, C2 may be established.

Behavior of the differential-amplifying unit 5 will now be discussed with reference to Fig. 2. The delay unit 41 feeds delay signal Y1 into the differential-amplifying unit 5 at one terminal thereof. The delay unit 42 enters delay signal Y2 into the differential-amplifying unit 5 at another terminal thereof.

The differential-amplifying unit 5 generates output signal "S2" according to a potential difference between respective delay signals Y1 and Y2.

Behavior of the serial/parallel-converting unit 6 will now be discussed. The differential-amplifying unit 5 enters signal S2 (a serial signal) into the serial/parallel-converting unit 6, in which signal S2 (the serial signal) is converted into parallel signal S3.

Behavior of the decoder 7 will now be described. The serial/parallel-converting unit 6 feeds parallel signal S3 (a redundant code) into the decoder 7. The decoder 7 decodes parallel signal S3 into original data, thereby providing the decoded original data.

Behavior of the error-detecting unit 43 will now be described. The serial/parallel-converting unit 6 feeds parallel signal S3 (the redundant code) into the error-detecting unit 43. The error-detecting unit 43 detects an error in parallel signal S3, and sends out error signal "E" to the counting unit 44 upon detection of the error.

Behavior of the counting unit 44 will now be discussed. The counting unit 44 counts the number of times of errors that occur within a predetermined time, upon receipt of error signal "E" that is sent from the error-detecting unit 43 each time when the error-detecting unit 43 detects the error in parallel signal S3. The counting unit 44 sends out information (a count value) on the counted times of errors per predetermined time to the delay control unit 45.

The counting unit 44 has a maximum countable value set therein, and functions to stop counting when counting up to the maximum value. In other words, the counting unit 44 is provided with an overflow-preventing function. The overflow function prevents malfunction of the counting unit 44.

Behavior of the delay control unit 45 will now be discussed. The differential signal-delaying unit 4 including the delay control unit 45 assumes adjustment and fixed modes.

It will now be described how the delay control unit 45 behaves when the differential signal-delaying unit 4 is in the adjustment mode.

In the adjustment mode, the delay control unit 45 controls respective voltages of control signals C1, C2 to be directed to the delay unit 41, 42, respectively. Such voltage control varies respective delay times in the delay unit 41, 42 in such a manner that a difference (hereinafter called a delay time difference) between the respective delay times in the delay unit 41, 42 is varied at certain time intervals.

Such a change in delay time difference to be made by the delay control unit 45 refers to respective variations in output timing of delay signal Y1 and that of delay signal Y2.

For each change in delay time difference to be made by the delay control unit 45, the counting unit 44 counts the number of times of errors that occur within a predetermined time, and then sends out a count value to the delay control unit 45.

The delay control unit 45 sets the respective delay times in the delay unit 41, 42 to respective delay times that determine a delay time difference in which the number of times of errors per predetermined time is minimized.

More specifically, the delay control unit 45 sets the respective voltages of control signals C1, C2 to respective voltages in which the number of times of errors per predetermined time is minimized.

The delay control unit 45 deactivates the error-detecting unit 43 and counting unit 44 after setting the respective voltages of control signals C1, C2, and the differential signal-delaying unit 4 is put into a fixed mode. As a result, reduced power consumption in the fixed mode is achievable.

The delay control unit 45 resets the count value in the counting unit 44 to zero for each change in delay time difference, while the counting unit 44 counts the number of times of errors per predetermined time for each change in delay time difference.

A specific example will now be described as to how the delay control unit 45 behaves when the differential signal-delaying unit 4 is in the adjustment mode.

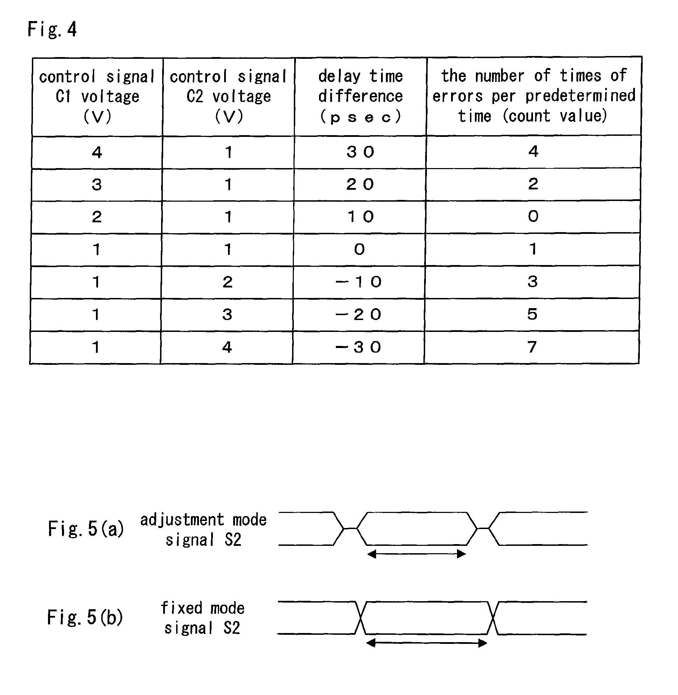

Fig. 4 is a descriptive illustration, showing behavior of the delay control unit 45 in the adjustment mode. Fig. 4 illustrates a relationship between respective voltages of control signal C1, C2 and a delay time difference when a relationship between the voltage of control signal C1 (or control signal C2) and a delay time in the delay unit 41 (or delay unit 42) is established in a manner as illustrated in Figs. 3 (c) and 3 (d).

For example, the delay time difference is 30 (psec) when control signals C1, C2 have respective voltages of 4 (V) and 1 (V). In Fig. 4, the delay time different is yielded by: the delay time in the delay unit 41 minus that in the delay unit 42.

As illustrated in Fig. 4, the delay control unit 45 varies the respective voltages of control signals C1, C2 in order to vary the delay time difference at certain time intervals, i.e., at 10-psec intervals.

The counting unit 44 counts the number of times of errors per predetermined time for each change in delay time difference to be made by the delay control unit 45, and then sends out a count value to the delay control unit 45.

In Fig. 4, when the delay time difference is 10 (psec), then the number of times of errors per predetermined time is minimized or rather zero.

Accordingly, the delay control unit 45 sets the respective voltages of control signals C1, C2 to 2 (V) and 1 (V), respectively, because 2 (V) and 1 (V) are voltages that are determined when the delay time difference is 10 (psec). The differential signal-delaying unit 4 is thereafter gone into a fixed mode.

When the respective voltages of control signals C1, C2 are set to 2 (V) and 1 (V), respectively, then the respective delay times in the delay unit 41, 42 are set to 20 (psec) and 10 (psec), respectively. (See Fig. 3 (d).)

As discussed above, the delay control unit 45 varies the delay time difference between the delay signals Y1, Y2. Such a variation in delay time difference refers to variations in difference in time in which delay signals Y1, Y2 arrive the differential-amplifying unit 5.

Such a difference in delay signal arrival time is what is called a differential signal skew.

Accordingly, the differential signal skew is varied with a change in delay time difference to be made by the delay control unit 45.

It can be assumed that the differential signal skew brings about errors whose number of times of the occurrence per predetermined time varies with a change in delay time difference. It can further be thought that a greater number of times of errors per predetermined time increase the differential signal skew, while a smaller number of times of errors per predetermined time decrease the differential signal skew.

The delay control unit 45 sets the respective delay times in the delay unit 41, 42 to a delay time difference in which the number of times of errors per predetermined time is minimized, i.e., a delay time difference in which the differential signal skew is minimized.

The above delay time-setting operation including the step of locating the delay time difference in which the number of times of errors per predetermined time is minimized provides a minimized differential signal skew. As a result, the occurrence of differential signal skew-caused errors is inhibited to the utmost.

The above beneficial effect is achievable regardless of whether or not the pair cable 3 is large in length. More specifically, although the differential signal-delaying unit 4 is thought to receive a differential signal with a greater skew through a longer pair cable 3 than through a shorter one, the above beneficial effect is provided irrespective of how large the skew is when the differential signal-delaying unit 4 receives the differential signal.

Consequently, the occurrence of differential signal skew-caused data errors is suppressed to an extreme extent, even when a pair cable longer than that in customary use is employed in the future. For example, video disturbance can be inhibited to the greatest degree, even with receipt of a video signal through a long pair cable.

Next, it will be discussed how the delay control unit 45 behaves when the differential signal-delaying unit 4 is in a fixed mode.

In the fixed mode, the delay control unit 45 continues to generate control signals C1, C2 after setting the respective voltages thereof to respective voltages in which the number of times of errors per predetermined time is minimized.

In Fig. 4, the delay control unit 45 continues to generate control signals C1, C2 after setting the voltages thereof to 2 (V) and 1 (V), respectively, in which the number of times of errors per predetermined time is minimized.

When there is a possibility that the existing pair cable may be replaced by another pair cable, e.g., when the receiver 2 is switched on or when a pair cable is inserted into the receiver 2, then the delay control unit 45 actuates the error-detecting unit 43 and the counting unit 44, and the differential signal-delaying unit 4 is put into the adjustment mode.

As discussed above, the differential signal-delaying unit 4 is brought back into the adjustment mode in response to a likelihood of pair cable replacement, even after the differential signal-delaying unit 4 is set into the fixed mode from the adjustment mode.

The pair cable replacement, of course, changes the differential signal skew, and the difference signal skew must be minimized by the above delay time-setting operation that includes the step of locating the delay time difference again in which the number of times of errors per predetermined time is minimized, in order to suppress the occurrence of differential signal skew-caused errors to the utmost.

As seen from Fig. 4, the delay time difference is controllable with ease when the respective delay times in the delay unit 41, 42 are linearly varied with the respective voltages of control signals C1, C2, respectively, as illustrated in Figs. 3 (c) and 3 (d).

Fig. 5 is a descriptive illustration, showing operations of the present embodiment.

Fig. 5 (a) illustrates an eye pattern (an overwritten waveform) of signal S2 sent from the differential-amplifying unit 5 when the differential signal-delaying unit 4 is in the adjustment mode. The shown signal S2 is generated when a differential signal skew is large, not when the number of times of errors per predetermined time is minimized.

In the adjustment mode, signal S2 has several waveforms (a waveform for each delay time difference).Fig.5(a) illustrates one of such waveforms, which includes a large-sized skew.

Fig. 5 (b) illustrates an eye pattern (an overwritten waveform) of signal S2 sent from the differential-amplifying unit 5 when the differential signal-delaying unit 4 is in the fixed mode. The shown signal S2 is generated when the number of times of errors per predetermined time is minimized, or rather when the differential signal skew is minimized.

As shown in Figs. 5 (a) and 5 (b), the eye pattern of signal S2 in the fixed mode (Fig. 5 (b)) is greater in openness in the direction of time lapse than that in the adjustment mode (Fig. 5 (a)).

This means that data is set to be 0 (zero) or otherwise 1 (one) at longer time intervals in the fixed mode that sets the respective delay times in the delay unit 41, 42 to a delay time difference in which the number of times of errors per predetermined time is minimized.

As a result, a data value is decided as either 0 (zero) or 1 (one) with improved certainty, and the occurrence of the difference signal skew-caused errors is inhibited to an extreme extent.

In order to provide the above-described communication system consistent with the DVI specification, the transmitter 1, serial/parallel-converting unit 6, and decoder 1 as illustrated in Fig. 1 and the error-detecting unit 43 of Fig. 2 are constructed in a manner described below. The remaining components are constructed in a manner discussed above.

The transmitter 1 encodes original 8-bit data (e.g., a 8-bit video signal), thereby producing a 10-bit redundant code including 2-bit redundant bit (hereinafter called a 8B10B code). Such encoding is practiced according to an algorithm that conforms to the DVI specification. The other aspects of the transmitter 1 are similar to those previously described.

The differential-amplifying unit 5 feeds signal S2 (a 10-bit serial signal) to the serial/parallel-converting unit 6, in which signal S2 is converted into 10-bit parallel signal S3.

The serial/parallel-converting unit 6 enters parallel signal S3 (the 8B10B code) into decoder 7. The decoder 7 decodes parallel signal S3 into original 8-bit parallel data, thereby providing the decoded data. Such decoding is practiced according to an algorithm that conforms to the DVI specification.

The serial/parallel-converting unit 6 feeds parallel signal S3 (the 8B10B code) into the error-detecting unit 43. The error-detecting unit 43 detects an error in parallel signal S3. Upon detection of the error, the error-detecting unit 43 sends out error signal "E" to the counting unit 44.

The error detection will now be described in more detail. The error-detecting unit 43 detects a word from the 8B10B code that is fed from the serial/parallel-converting unit 6, which word is absent in an 8B10B code word list (a word list in which the original 8-bit data is provided when the 8B10B code is decoded). Upon detection of the word, the error-detecting unit 43 sends out the error signal to the counting unit 44.

For example, the error-detecting unit 43 is achievable by means of ROM (a read-only memory) having a 10-bit input width in order to feed 10-bit parallel signal S3 into the error-detecting unit 43 and further having a 1-bit output width in order to generate error signal "E."

The present invention is not limited to ROM. For example, the error-detecting unit 43 can be realized by an AND-OR gate, or alternatively by any other methods publicly known to those skilled in the art.

The above construction allows the communication system according to the present embodiment to be maintained compatible in code with standards according to the DVI specification. This means that the occurrence of differential signal skew-caused errors is limited to an extreme extent, even with the use of a redundant code or rather 8B10B code, which is produced by means of an encoding algorithm according to the DVI specification.

### (Embodiment 2)

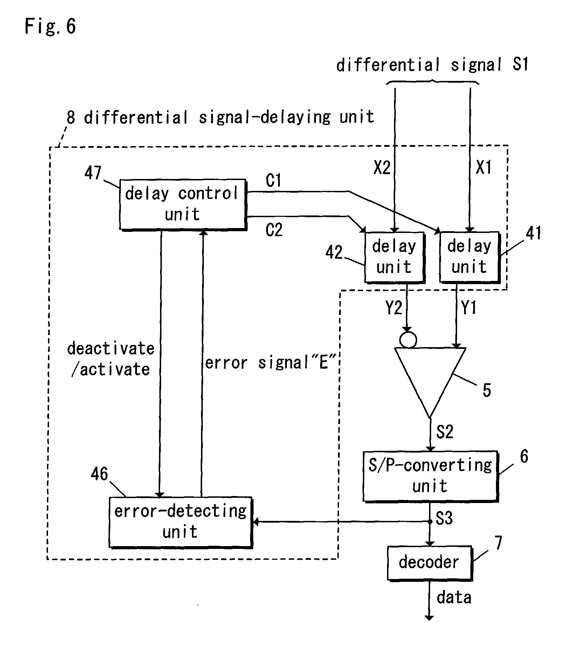

Fig. 6 is a block diagram, illustrating a receiver according to a second embodiment. A communication system including the receiver is similar in construction to the communication system as illustrated in Fig. 1. In Fig. 6, the same components as those of Fig. 2 are identified by the same characters, and descriptions related thereto are omitted.

As illustrated in Fig. 6, a differential signal-delaying unit 8 according to the present embodiment includes a pair of delay unit 41, 42, an error-detecting unit 46, and a delay control unit 47. The differential signal-delaying unit 8 differs in the absence of the counting unit 44 from the differential signal-delaying unit 4 according to the first embodiment as illustrated in Fig. 2.

It will now be discussed with reference to Fig. 6 how the error-detecting unit 46 behaves. The serial/parallel-converting unit 6 feeds parallel signal S3 (a redundant signal) into the error-detecting unit 46, in which an error in parallel signal S3 is detected. Upon detection of the error, the error-detecting unit 46 sends out error signal "E" to the delay control unit 47.

Behavior of the delay control unit 47 will now be discussed. Similar to the previous embodiment, the differential signal-delaying unit 8 including the delay control unit 47 assume adjustment and fixed modes.

It will initially be described how the delay control unit 47 behaves when the differential signal-delaying unit 8 is in the adjustment mode.

In the adjustment mode, the delay control unit 47 controls respective voltages of control signals C1, C2 to be entered into the delay unit 41, 42, respectively. Such voltage control varies respective delay times in the delay unit 41, 42 in such a manner that a difference (delay time difference) between the respective delay times in the delay unit 41, 42 is varied at given time intervals.

The delay control unit 47 sets the respective delay times in the delay unit 41, 42 to respective delay times that determine a delay time difference in which no error is detected by the error-detecting unit 46.

More specifically, the delay control unit 47 sets the respective voltages of control signals C1, C2 to respective voltages thereof in which no error is detected.

Following the above voltage-setting operation, the delay control unit 47 deactivates the error-detecting unit 46, and then the differential signal-delaying unit 8 is put into a fixed mode. As a result, reduced power consumption in the fixed mode is achievable.

The delay control unit 47 checks the error signal from error-detecting unit 46 to see whether an error has been detected.

As described above, the delay control unit 47 sets the respective delay times in the delay unit 41, 42 to a delay time difference in which no error is detected, i.e., a delay time difference in which a differential signal skew is minimized.

The above delay time-setting operation including the step of locating the delay time difference in which no error is detected provides a minimized differential signal skew, thereby making it feasible to limit the occurrence of differential signal skew-caused errors as much as possible.

Similar to the previous embodiment, the above beneficial effect is achievable regardless of whether or not the pair cable 3 is large in length.

As a result, the occurrence of differential signal skew-caused data errors is inhibited to the utmost, even when a pair cable longer than that in customary use is employed in the future. For example, video disturbance can be suppressed to an extreme extent, even when a video signal is received through a long pair cable.

In addition, the present embodiment eliminates the counting unit 44 as opposed to the previous embodiment, and such a simpler construction provides the above beneficial effect.

The fixed mode will now be described.

When the differential signal-delaying unit is in the fixed mode, the delay control unit 47 continues to generate control signals C1, C2 after setting the respective voltages of control signals C1, C2 to respective voltages thereof in which no error is detected.

When there is likelihood that the existing pair cable is replaced by another pair cable, e.g. when the receiver 2 is switched on or when a pair cable is inserted into the receiver 2, then the delay control unit 47 actuates the error-detecting unit 46, and the differential signal-delaying unit 8 is put into the adjustment mode. This step is taken for a reason similar to that in the previous embodiment.

Similar to the first embodiment, the above-described communication system that conforms to the DVI specification is achievable.

Having described preferred embodiments of the invention with reference to the accompanying drawings, it is to be understood that the invention is not limited to those precise embodiments, and that various changes and modifications may be effected therein by one skilled in the art without departing from the scope or spirit of the invention as defined in the appended claims.

## Claims

1. A differential signal-delaying apparatus(4) comprising:
a first delay means(41) for delaying a first signal of an entered differential signal in order to generate a first delay signal;
a second delay means(42) for delaying a second signal of the entered differential signal in order to generate a second delay signal;
an error-detecting means(43) for generating an error signal when detecting an error in a signal that is based on the first and second delay signals;
a counting means(44) for counting number of times of errors per predetermined time upon receipt of the error signal; and
a delay control means(45) for varying a delay time difference that is a difference between respective delay times in the first and second delay means(41,42),
wherein the counting means(44) counts the number of times of errors per predetermined time for each change in the delay time difference to be made by the delay control means(45), and
wherein the delay control means(45) sets the respective delay times in the first and second delay means(41,42) to respective delay times that determine a delay time difference in which the number of times of errors per predetermined time is minimized.

2. A differential signal-delaying apparatus(4) as defined in claim 1, wherein the delay control means(45) starts changing the delay time difference in one of cases where the differential signal-delaying apparatus(4) is switched on and where a pair cable(3) for use in entering the differential signal is inserted, and then the delay control means(45) sets the respective delay times in the first and second delay means(41,42) to respective delay times that determine a delay time difference in which the number of times of errors per predetermined time is minimized.

3. A differential signal-delaying apparatus(4) as defined in claim 1, wherein the delay control means(45) deactivates the error-detecting means(43) and the counting means(44) when setting the respective delay times in the first and second delay means(41,42).

4. A differential signal-delaying apparatus(8) comprising:
a first delay means(41) for delaying a first signal of an entered differential signal in order to generate a first delay signal;
a second delay means(42) for delaying a second signal of the entered differential signal in order to generate a second delay signal;
an error-detecting means(46) for detecting an error in a signal that is based on the first and second delay signals; and
a delay control means(47) for varying a delay time difference that is a difference between respective delay times in the first and second delay means(41,42),
wherein the error-detecting means(46) detects the error for each change in the delay time difference to be made by the delay control means(47), and
wherein the delay control means(47) sets the respective delay times in the first and second delay means(41,42) to respective delay times that determine a delay time difference in which no error is detected.

5. A differential signal-delaying apparatus(8) as defined in claim 4, wherein the delay control means(47) starts changing the delay time difference in one of cases where the differential signal-delaying apparatus(8) is switched on and where when a pair cable(3) for use in entering the differential signal is inserted, and then the delay control means(47) sets the respective delay times in the first and second delay means(41,42) to respective delay times that determine a delay time difference in which no error is detected.

6. A differential signal-delaying apparatus(8) as defined in claim 4, wherein the delay control means(47) deactivates the error-detecting means(46) when setting the respective delay times in the first and second delay means(41,42).

7. A differential signal-delaying apparatus(4) as defined in claim 1, wherein the delay control means(45) varies the delay time difference by controlling the respective delay times in the first and second delay means(41,42) by means of first and second control signals to be fed into the first and second delay means(41,42), respectively, and wherein the delay time in the first delay means(41) is linearly varied with a voltage of the first control signal, while the delay time in the second delay means(42) is linearly varied with a voltage of the second control signal.

8. A differential signal-delaying apparatus(8) as defined in claim 4, wherein the delay control means(47) varies the delay time difference by controlling the respective delay times in the first and second delay means(41,42) by means of first and second control signals to be fed into the first and second delay means(41,42), respectively, and wherein the delay time in the first delay means(41) is linearly varied with a voltage of the first control signal, while the delay time in the second delay means(42) is linearly varied with a voltage of the second control signal.

9. A receiver(2) for receiving a differential signal that includes first and second signals, each of which is a serial signal, comprising:
a differential signal-delaying means(4) for delaying the first and second signals of the differential signal in order to provide the delayed first and second signals as first and second delay signals, respectively;
a differential-amplifying means(5) for generating an output signal according to a potential difference between the first and second delay signals;
a serial/parallel-converting means(6) for converting the output signal into a parallel signal, the output signal being a serial signal sent out from the differential-amplifying means(5); and
a decoder(7) for decoding the parallel signal from the serial/parallel-converting means(6),
the differential signal-delaying means(4) comprising:
a first delay means(41) for delaying the first signal of the differential signal in order to generate the first delay signal;
a second delay means(42) for delaying the second signal of the differential signal in order to produce the second delay signal;
an error-detecting means(43) for generating an error signal when detecting an error in the parallel signal from the serial/parallel-converting means(6);
a counting means(44) for counting number of times of errors per predetermined time upon receipt of the error signal; and
a delay control means(45) for varying a delay time difference that is a difference between respective delay times in the first and second delay means(41,42),
wherein the counting means(44) counts the number of times of errors per predetermined time for each change in the delay time difference to be made by the delay control means(45), and
wherein the delay control means(45) sets the respective delay times in the first and second delay means(41,42) to respective delay times that determine a delay time difference in which the number of times of errors per predetermined time is minimized.

10. A receiver(2) as defined in claim 9, wherein the delay control means(45) starts changing the delay time difference in one of cases where the receiver(2) is switched on and where a pair cable(3) for use in feeding the differential signal is inserted into the receiver(2), and then the delay control means(45) sets the respective delay times in the first and second delay means(41,42) to respective delay times that determine a delay time difference in which the number of times of errors per predetermined time is minimized.

11. A receiver(2) as defined in claim 9, wherein the delay control means(45) deactivates the error-detecting means(43) and the counting means(44) when setting the respective delay times in the first and second delay means(41,42).

12. A receiver(2) for receiving a differential signal that includes first and second signals, each of which is a serial signal, comprising:
a differential signal-delaying means(8) for delaying the first and second signals of the differential signal in order to provide the delayed first and second signals as first and second delay signals, respectively;
a differential-amplifying means(5) for generating an output signal according to a potential difference between the first and second delay signals;
a serial/parallel-converting means(6) for converting the output signal into a parallel signal, the output signal being a serial signal sent out from the differential-amplifying means(5); and
a decoder(7) for decoding the parallel signal from the serial/parallel-converting means(6),
the differential signal-delaying means(8) comprising:
a first delay means(41) for delaying the first signal of the differential signal in order to generate the first delay signal;
a second delay means(42) for delaying the second signal of the differential signal in order to produce the second delay signal;
an error-detecting means(46) for detecting an error in the parallel signal from the serial/parallel-converting means(6); and
a delay control means(47) for varying a delay time difference that is a difference between respective delay times in the first and second delay means(41,42),
wherein the error-detecting means(46) detects the error for each change in the delay time difference to be made by the delay control means(47), and
wherein the delay control means(47) sets the respective delay times in the first and second delay means(41,42) to respective delay times that determine a delay time difference in which no error is detected.

13. A receiver(2) as defined in claim 12, wherein the delay control means(47) starts changing the delay time difference in one of cases where the receiver(2) is switched on and where a pair cable(3) for use in feeding the differential signal is inserted into the receiver(2), and then the delay control means(47) sets the respective delay times in the first and second delay means(41,42) to respective delay times that determine a delay time difference in which no error is detected.

14. A receiver(2) as defined in claim 12, wherein the delay control means(47) deactivates the error-detecting means(46) when setting the respective delay times in the first and second delay means(41,42).

15. A receiver(2) as defined in claim 9, wherein the receiver(2) receives the differential signal that includes first and second signals, each of which is a 10-bit redundant code, and wherein the decoder(7) decodes the parallel signal from the serial/parallel-converting means(6), the parallel signal being the 10-bit redundant code, thereby providing the decoded parallel signal as 8-bit parallel data.

16. A receiver(2) as defined in claim 12, wherein the receiver(2) receives the differential signal that includes first and second signals, each of which is a 10-bit redundant code, and wherein the decoder(7) decodes the parallel signal from the serial/parallel-converting means(6), the parallel signal being the 10-bit redundant code, thereby providing the decoded parallel signal as 8-bit parallel data.

17. A receiver(2) as defined in claim 9, wherein the delay control means(45) varies the delay time difference by controlling the respective delay times in the first and second delay means(41,42) by means of first and second control signals to be entered into the first and second delay means(41,42), respectively, and wherein the delay time in the first delay means(41) is linearly varied with a voltage of the first control signal, while the delay time in the second delay means(42) is linearly varied with a voltage of the second control signal.

18. A receiver(2) as defined in claim 12, wherein the delay control means(47) varies the delay time difference by controlling the respective delay times in the first and second delay means(41,42) by means of first and second control signals to be entered into the first and second delay means(41,42), respectively, and wherein the delay time in the first delay means(41) is linearly varied with a voltage of the first control signal, while the delay time in the second delay means(42) is linearly varied with a voltage of the second control signal.

19. A communication system including a transmitter(1) and a receiver(2), which are communicated with one another through a pair cable(3),
the receiver(2) receiving a differential signal from the transmitter(1), the receiver(2) comprising a differential signal-delaying means(4) for delaying the differential signal,
the differential signal-delaying means(4) comprising:
a first delay means(41) for delaying a first signal of the differential signal in order to generate a first delay signal;
a second delay means(42) for delaying a second signal of the differential signal in order to generate a second delay signal;
an error-detecting means(43) for generating an error signal when detecting an error in a signal that is based on the first and second delay signals;
a counting means(44) for counting number of times of errors per predetermined time upon receipt of the error signal; and
a delay control means(45) for varying a delay time difference that is a difference between respective delay times in the first and second delay means(41,42),
wherein the counting means(44) counts the number of times of errors per predetermined time for each change in the delay time difference to be made by the delay control means(45), and
wherein the delay control means(45) sets the respective delay times in the first and second delay means(41,42) to respective delay times that determine a delay time difference in which the number of times of errors per predetermined time is minimized.

20. A communication system including a transmitter(1) and a receiver(2), which are communicated with one another through a pair cable(3),
the receiver(2) receiving a differential signal from the transmitter(1), the receiver(2) comprising a differential signal-delaying means(8) for delaying the differential signal,
the differential signal-delaying means(8) comprising:
a first delay means(41) for delaying a first signal of the differential signal in order to generate a first delay signal;
a second delay means(42) for delaying a second signal of the differential signal in order to generate a second delay signal;
an error-detecting means(46) for detecting an error in a signal that is based on the first and second delay signals; and
a delay control means(47) for varying a delay time difference that is a difference between respective delay times in the first and second delay means(41,42),
wherein the error-detecting means(46) detects the error for each change in the delay time difference to be made by the delay control means(41,42), and
wherein the delay control means(47) sets the respective delay times in the first and second delay means(41,42) to respective delay times that determine a delay time difference in which no error is detected.
